# EUROPEAN PATENT APPLICATION

(11) **EP 4 770 327 A1**
(43) Date of publication of application: **01.07.2026**
(21) Application number: 25218713.3
(22) Date of filing: 26.11.2025
(51) Int. Cl.: H10D 62/10, H10D 30/01, H10D 30/43, H10D 30/00, H10D 84/01, H10D 84/83, H10D 84/85, H10D 30/67, H10D 84/03

(54) **MULTI-THRESHOLD GATE DIELECTRIC PATTERNING SCHEME USING INDIVIDUALIZED GATE TUBS**

(30) Priority: 26.12.2024 US 202419002315
(71) Applicant: INTEL Corporation, Santa Clara, CA 95054 (US)
(72) Inventor: LAVRIC, Dan, Portland, OR 97229 (US); CAO, Yang, Beaverton, OR 97006 (US); LOH, Owen, Portland, OR 97221 (US); TOWNER, David, Portland, OR 97225 (US)
(74) Representative: Samson & Partner Patentanwälte mbB

(57) **Abstract**

Integrated circuit (IC) devices having gate-all-around (GAA) transistors. An IC device may include adjacent GAA transistors with gate electrodes having different gate dielectric stacks separated by a dielectric wall. The gate dielectric stacks may include inner gate dielectric layers on nanoribbon channels and outer gate dielectric layers on the inner gate dielectric layers. The inner gate dielectric layers of the adjacent transistors may have different thicknesses or material compositions. The outer gate dielectric layers of the adjacent transistors may have different thicknesses or material compositions. The dielectric wall between gate electrodes and gate dielectric stacks may enable independent processing of the transistors gates by dividing the nanoribbon channels into separate gate tubs.

## Description

### BACKGROUND

In conventional processing of gate-all-around (GAA) transistors, the gate electrodes and gate insulators of millions of transistors are fabricated concurrently and with matching characteristics (such as gate dielectric thickness). Limited modifications in gate processing for complementary transistors (e.g., differences between n- and p-type transistor fabrication) may cause surface defects and excessive consumption of channel material. For example, repeated deposition and removal of masking layers may consume channel materials and/or damage channel materials or gate dielectrics.

New techniques, structures, and materials are needed to improve the performance and reliability of integrated circuit (IC) devices, for example, by providing multiple transistor gate variants whose characteristics (such as leakage or switching speed) may be matched to particular applications.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIGS. 1A, 1B, and 1C illustrate cross-sectional profile and plan views of an integrated circuit (IC) device with transistor structures having different gate stacks in adjacent gate electrodes separated by a slim dielectric wall, in accordance with some embodiments;
FIG. 2 is a flow chart of methods for forming different gate stacks in adjacent transistors, in accordance with some embodiments;
FIGS. 3A, 3B, 3C, 3D, 3E, 3F, 3G, 3H, 3I, 3J, 3K, and 3L illustrate cross-sectional profile views of a workpiece or device with transistor structures having different gate stacks in adjacent gate electrodes separated by a slim dielectric wall, at various stages of manufacture, in accordance with some embodiments;
FIG. 4 illustrates a diagram of an example data server machine employing an IC device having a dielectric wall separating gate electrodes with different gate dielectric stacks; and
FIG. 5 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Techniques, structures, and materials are disclosed to improve integrated circuit (IC) devices having gate-all-around (GAA) metal-oxide-semiconductor (MOS) field-effect transistors (FETs).

Dielectric walls may separate adjacent nanoribbon stacks into individual processing compartments ("tubs"), thereby enabling independent fabrication of gate dielectric stacks in adjacent GAA FETs. Instead of every nanoribbon stack in a shared gate trench undergoing the same processing, each nanoribbon stack may have its own gate tub and receive specifically tailored processing. The dielectric walls may be formed by making many etches through long dummy gates in gate trenches and by filling the etched openings with dielectric, forming many isolations between many nanoribbon stacks. Openings may be patterned through a hardmask layer deposited over the walls and nanoribbon stacks, and dummy gate material may be removed through the openings, evacuating selected tubs between the dielectric walls.

The mask openings may be made to evacuate groups of tubs selected for a particular processing operation. For example, the gate tubs for all (or at least many) nanoribbon stacks to receive a certain gate dielectric material or thickness may be evacuated together and then receive the further processing concurrently. The hardmask layer may be removed following the completion of the particular processing operation, a new hardmask layer may be deposited, and new openings may be patterned to evacuate a new group of tubs for a next processing operation (e.g., the formation of a second gate dielectric material or thickness). The dielectric walls may be retained after gate formation as electrical isolation between adjacent metal gate electrodes.

The tailored processing enabled by the gate tubs may be used to provide multiple gate variants, for example, having different threshold voltages V_{T} and corresponding leakages and switching speeds. An IC device may have multiple gate variants for each of multiple complementary conductivity types. For example, an IC device may have a spread of four or more threshold voltages V_{T} among NMOS FETs and a spread of four or more threshold voltages V_{T} among PMOS FETs. In many embodiments, adjacent transistors have different thicknesses of gate dielectric layers directly on channel nanoribbons. In many embodiments, adjacent transistors have different thicknesses of gate dielectric layers (e.g., high-permittivity or "high-k" layers) over the layers directly on the nanoribbons. For example, gate dielectric layer thicknesses may differ by 2 angstroms (or as much as 5 angstroms) in adjacent transistors. In many embodiments, adjacent transistors have gate dielectric layers with different high-k materials. In some embodiments, adjacent transistors have gate dielectric layers with different material compositions (e.g., elemental ratios) of the same high-k materials.

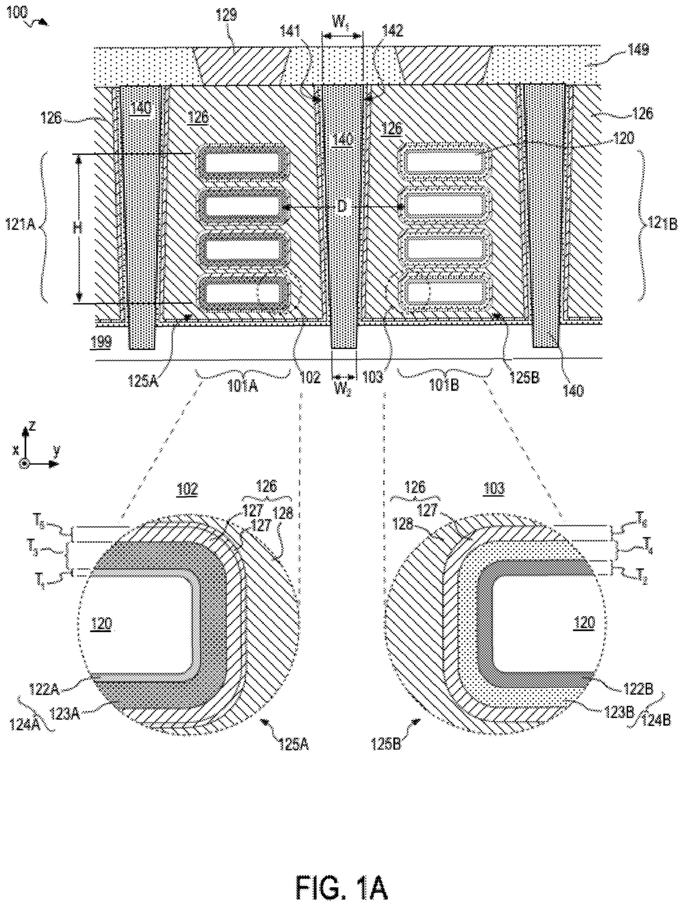

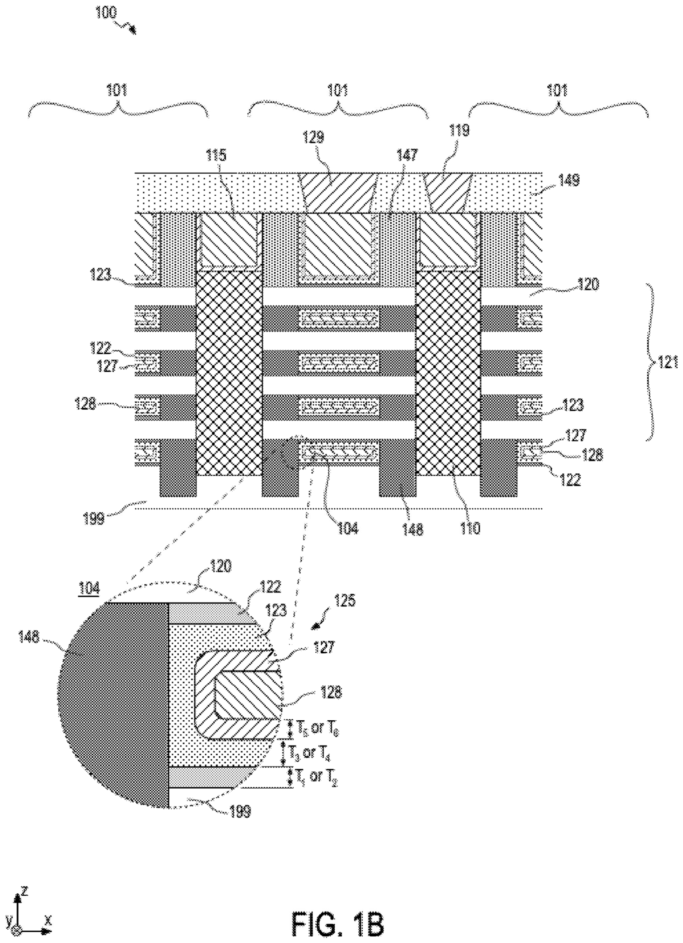

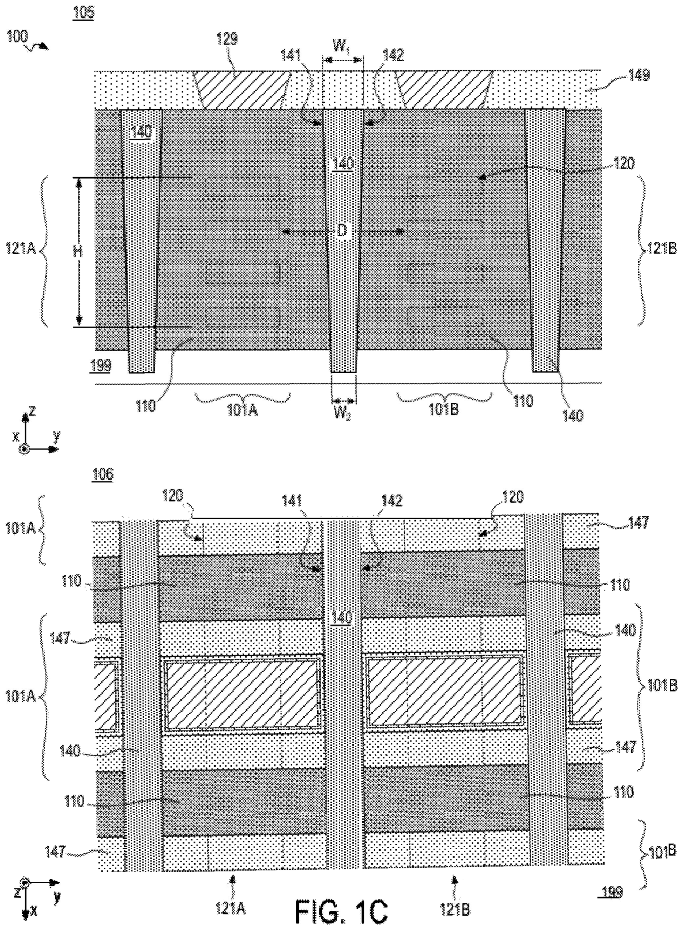

FIGS. 1A, 1B, and 1C illustrate cross-sectional profile and plan views of an IC device 100 with transistor structures 101A, 101B having different gate stacks 125A, 125B in adjacent gate electrodes 126 separated by a slim dielectric wall 140, in accordance with some embodiments. Transistor structures 101A, 101B are GAA FET structures 101 having channel regions in stacks 121A, 121B of nanoribbons 120. FIG. 1A shows a y-z viewing plane transversely through nanoribbons 120 in multiple, adjacent stacks 121A, 121B and transistor structures 101. FIG. 1A includes multiple (e.g., enlarged) views 102, 103 of gate stacks 125A, 125B on nanoribbons 120. FIG. 1B illustrates an x-z viewing plane longitudinally through nanoribbons 120 in multiple, aligned stacks 121 and transistor structures 101. FIG. 1B includes multiple (e.g., enlarged) views 104 of a gate stack 125 adjacent a nanoribbon 120. FIG. 1C shows a y-z profile view 105 and an x-y plan view 106, both through dielectric walls 140 between and in contact with source or drain bodies 110 in transistor structures 101A, 101B.

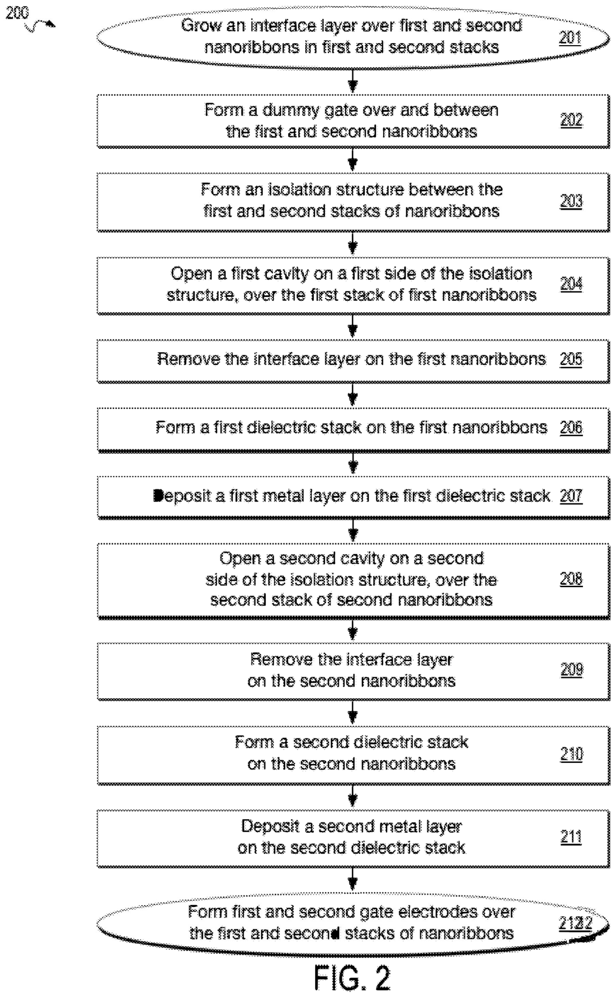

FIG. 1A shows device 100 including isolation wall 140 between and separating first and second gate stacks 125A, 125B in transistor structures 101A, 101B, respectively. Isolation wall 140 is a dielectric structure on (e.g., in contact with) both of stacks 125A, 125B. Wall 140, separating gate stacks 125A, 125B and electrodes 126, extends vertically from above the tops (e.g., upper surfaces) of electrodes 126 to below the bottoms (e.g., lower surfaces) of electrodes 126. Dielectric wall 140 provides isolation (e.g., electrical isolation) between gate electrodes 126 of structures 101A, 101B. A thin wall 140 enables the tight packing of transistor structures 101A, 101B and gate electrodes 126 in device 100. Dielectric wall 140 also enables the independent processing of gate stacks 125A, 125B in structures 101A, 101B (e.g., as described elsewhere herein, such as at FIG. 2 and methods 200), which allows for stacks 125 having different insulator layers 122, 123, etc., for example, with different thicknesses, materials, etc. Each wall 140 is between a pair of gate electrodes 126, and each electrode 126 is between a pair of dielectric walls 140.

Transistor structures 101A, 101B may be of the same or of complementary conductivity types (e.g., PMOS and/or NMOS structures 101A, 101B). For example, transistor structure 101A may be a p-type structure 101A, and transistor structure 101B may be an n-type structure 101B, or vice versa. Both of transistor structures 101A, 101B are of the same conductivity type (e.g., both PMOS structures 101A, 101B or both NMOS structures 101A, 101B).

Transistor structure 101A includes a first stack 121A of first nanoribbons 120 extending through first gate stack 125A. Transistor structure 101B includes a second stack 121B of second nanoribbons 120 extending through second gate stack 125B. As in the exemplary embodiment of FIG. 1A, first and second gate stacks 125A, 125B may have different first and second stack compositions. The difference between the first and second compositions of stacks 125A, 125B, respectively, may be that stacks 125A, 125B include a different quantity of layers (e.g., more or different layers), similar layers but with different materials, etc. For example, first and second compositions of gate stacks 125A, 125B may differ by only (exactly) one of stacks 125A, 125B having a high-k dielectric layer 123 on a transition layer 122.

First gate stack 125A includes a first dielectric stack 124A on first nanoribbons 120, and gate stack 125A includes one or more first metal layers 127 on dielectric stack 124A. View 102 shows an embodiment having multiple layers 127 on stack 124A. First dielectric stack 124A includes dielectric layers 122A on first nanoribbons 120 and insulator layers 123A on dielectric layers 122A. First gate stack 125A may also include a metal (e.g., fill) layer 128 on liner layer 127.

Second gate stack 125B includes a second dielectric stack 124B on second nanoribbons 120, and gate stack 125B includes one or more second metal layers 127 on dielectric stack 124B. Second dielectric stack 124B includes dielectric layers 122B on second nanoribbons 120 and insulator layers 123B on dielectric layers 122B. Second gate stack 125B may also include a metal (e.g., fill) layer 128 on liner layer 127.

Dielectric layers 122 (e.g., layers 122A, 122B) may include any suitable material(s) and may have any suitable thickness(es). Layers 122A, 122B are on nanoribbons 120 in transistor structures 101A, 101B, respectively, and may provide protection to nanoribbons 120, e.g., during processing. For example, layers 122A, 122B may be passivation layers 122A, 122B, e.g., of a native oxide of a material in nanoribbons 120. In many embodiments, dielectric layers 122 include silicon and oxygen. Layers 122A, 122B may be transition layers 122 between nanoribbons 120 and other layers (such as layers 123, etc.) over layers 122. In some embodiments, dielectric layers 122A, 122B have thicknesses T₁, T₂ less than thicknesses of other layers over layers 122A, 122B. In many embodiments, dielectric layers 122A have a thickness T₁ greater than (or less than) a thickness T₂ of dielectric layers 122B. For example, layer 122A may have a thickness T₁ of 1 nm or less and layer 122B may have a thickness T₂ of 1.3 nm or more. In some embodiments, one of layers 122A, 122B includes a material not included in the other of layers 122A, 122B. Layers 122 may include other suitable materials. Different thicknesses T₁ or T₂ (or different material compositions) of layers 122A, 122B may provide different threshold voltages V_{T} for transistor structures 101A, 101B. Different thicknesses T₁ or T₂ of layers 122A, 122B may provide different thicknesses of nanoribbons 120 in transistor structures 101A, 101B.

Insulator layers 123 (e.g., layers 123A, 123B) may include any suitable material(s) and may have any suitable thickness(es). Layers 123A, 123B are on transition layers 122A, 122B in transistor structures 101A, 101B, respectively. In many embodiments, insulator layers 123A, 123B have thicknesses T₃, T₄ greater than thicknesses T₁, T₂ of layers 122A, 122B on nanoribbons 120. Insulator layers 123 may be dielectric layers 123. For example, layers 123A, 123B advantageously include one or more high-k dielectric materials, which may provide design flexibility and/or superior characteristics (such as electrical characteristics) when deployed with, or instead of, other materials.

Layers 123 (e.g., high-k layers 123A, 123B) may allow for a greater transconductance gₘ (e.g., for a same voltage on gate electrode 126 and same thickness T₃ or T₄) in transistor structures 101A, 101B. High-k layers 123 may allow for greater total thicknesses (e.g., thickness T₁ plus thickness T₃ in stack 125A or thickness T₂ plus thickness T₄ in stack 125B) of dielectric over nanoribbons 120, and so may enable low leakage currents in structures 101A, 101B (e.g., for a same voltage on gate electrode 126 while maintain a same transconductance gₘ). High-k layers 123A, 123B may enable low leakage currents in structures 101A, 101B, e.g., with a lower voltage on gate electrode 126 and a same thickness T₃ or T₄. In many embodiments, insulator layers 123A have a thickness T₃ greater than (or less than) thickness T₄ of insulator layers 123B. For example, layer 123A may have a thickness T₃ of 1.3 nm or less and layer 122B may have a thickness T₄ of 1.8 nm or more. Different thicknesses T₃ or T₄ (or different material compositions) of layers 123A, 123B may provide different threshold voltages V_{T} for transistor structures 101A, 101B.

Insulator layers 123 may include any suitable material(s). In many embodiments, insulator layers 123 include hafnium and oxygen. In some embodiments, insulator layers 123 include zirconium and oxygen. In some embodiments, insulator layers 123 include hafnium, zirconium, and oxygen. In some embodiments, insulator layers 123A, 123B have different material compositions. In some embodiments, for example, insulator layers 123A (or layers 123B) include hafnium and zirconium, and insulator layers 123B (or layers 123A) include neither, or only one, of hafnium and zirconium (e.g., hafnium but not zirconium, or zirconium but not hafnium). In some embodiments, layers 123A, 123B both include hafnium, zirconium, and oxygen (HZO, e.g., in hafnium zirconate or hafnium zirconium oxide), but at different elemental ratios. The material compositions of one or both of layers 123A, 123B (e.g., the ratio of hafnium to zirconium) may be varied to increase a relative permittivity of layer 123A and/or 123B (e.g., from about 1:1 to about 2:1 or more). In some embodiments, a dopant (e.g., yttrium) is added to one or both of layers 123A, 123B to increase a relative permittivity of layer 123A and/or 123B (e.g., by increasing a proportion of higher-permittivity dielectric phase in layer(s) 123). Either or both of layers 123A, 123B may include one or more of various elements, such as hafnium, zirconium, silicon, oxygen, titanium, tantalum, lanthanum, aluminum, barium, strontium, yttrium, lead, scandium, niobium, and zinc. Layers 123 may include other suitable materials.

First and second gate stacks 125A, 125B may include a dipole dopant. In some embodiments, one of first and second gate stacks 125A, 125B includes a dipole dopant not present in the other of gate stacks 125A, 125B. In some embodiments, first and second gate stacks 125A, 125B include a same dipole dopant, but the dipole dopant is present at a first height (e.g., of a sum of thicknesses T₁, T₃) from nanoribbons 120 in stack 121A greater (or lesser) than a second height (e.g., of a sum of thicknesses T₂, T₄) from nanoribbons 120 in stack 121B. The same dipole dopant may be within different layers 122, 123 (or at a different interface of layers 122, 123) in the different dielectric stacks 124A, 124B.

Gate electrodes 126 (and gate stacks 125A, 125B) may include one or more metal layers 127, 128. Gate electrodes 126, together with first and second dielectric stacks 124A, 124B, form first and second gate structures for electrostatically controlling the conduction of transistor structures 101A, 101B. Layers 127, 128 may be workfunction metal (WFM) layers 127, 128, e.g., to (e.g., independently) influence threshold voltages V_{T} of transistor structures 101A, 101B. Layers 127 may be conformal, liner layers 127 around nanoribbons 120 and dielectric stacks 124, e.g., with a first metal layer 127 on insulator layer 123A around each of nanoribbons 120 in structure 101A and a second metal layer 127 on insulator layer 123B around each of nanoribbons 120 in structure 101B. Transistor structure 101A and gate stack 125A may include one or more metal layers 127 in electrode 126. Transistor structure 101B and gate stack 125B may include one or more metal layers 127 in electrode 126.

Liner layers 127 in structures 101A, 101B may have different thicknesses T₅, T₆, respectively, for example, with a thickness T₅ (or thickness T₆) greater than a thickness T₆ (or thickness T₅) and having a correspondingly larger impact on the threshold voltage V_{T} of transistor structure 101A (or structure 101B). Layers 127 in structures 101A, 101B may have different material compositions. Fill layers 128 in structures 101A, 101B may have different material compositions. Layers 127, 128 may include any suitable material(s), including non-metals. In many embodiments, layers 127 include nitrogen (e.g., in a metal nitride) or carbon (e.g., in a metal carbide). In some such embodiments, layers 127 include nitrogen and titanium, molybdenum, or tantalum. In some embodiments, a first layer 127 on a dielectric stack 124 includes titanium and nitrogen, and a second layer 127 on first layer 127 includes nitrogen and tantalum or molybdenum. In some embodiments, layer 127 includes titanium, aluminum, and carbon. In many embodiments, layer 128 includes tungsten.

Wall 140 includes opposing first and second sidewalls 141, 142. A width W₁ (or width W₂) of dielectric wall 140 separates sidewalls 141, 142. Width W₁ (or width W₂) separates gate electrodes 126 (and first and second gate stacks 125A, 125B) in transistor structures 101A, 101B (respectively). Dielectric wall 140 (e.g., sidewalls 141, 142) may be nearly vertical. In many embodiments, dielectric wall 140 has widths W₁, W₂ differing only slightly (e.g., in a tapering profile that narrows slightly upwards or downwards. For example, widths W₁, W₂ may be within 1 nm. Width W₁ is defined as the width of wall 140 at a top of wall 140. Width W₂ is defined as the width of wall 140 at a bottom of bodies 110, e.g., where wall 140 meets substrate 199 at a bottom of body 110. Gate electrodes 126 are separated by dielectric wall 140 and a minimum distance or width W₂ (or width W₁, etc.) between electrodes 126 (and stacks 125). In many embodiments, dielectric wall 140 has a minimum width W₂ (or width W₁, etc.) of 12 nm or less between electrodes 126 (and stacks 125), which may enable sufficiently tight packing of transistor structures 101A, 101B and a consequent conservation of layout area. In some embodiments, dielectric wall 140 has a minimum width W₂ (or width W₁, etc.) of 10 nm or less between electrodes 126 (and stacks 125), which may enable superior packing of transistor structures 101A, 101B and conservation of layout area. Such (small widths W₁, W₂ and) tight laying out of structures 101 may be enabled by a fine, high aspect ratio etch (e.g., through and between metal gate electrodes 126).

The tight packing of stacks 121 and transistor structures 101 may also be characterized by a small distance D separating the first and second stacks 121A, 121B of nanoribbons 120. In many embodiments, distance D is less than three times a maximum width W₁ of wall 140 (e.g., with wall 140 centered between stacks 121, a width W₁ from either stack).

Isolation wall 140 includes any suitable material(s), for example, a dielectric material. Wall 140 advantageously includes a low-k (low-permittivity) dielectric material. Wall 140 advantageously has an etch selectivity with other adjacent structures. In many embodiments, wall 140 includes silicon and nitrogen (e.g., in a nitride of silicon). In some embodiments, wall 140 includes silicon and oxygen (e.g., in an oxide of silicon). In some embodiments, wall 140 includes carbon and/or nitrogen, for example, in addition to silicon and oxygen.

Isolation wall 140 may enable the independent processing of gate stacks 125A, 125B in structures 101A, 101B (e.g., as described at least at FIG. 2 and methods 200), which allows for stacks 125 of various compositions (e.g., having layers 122, 123, 127, etc., of different thicknesses T₁, T₂, T₃, T₄, T₅, T₆, and/or including different materials).

Much of the stacks 125A, 125B of layers around nanoribbons 120 are also on sidewalls 141, 142 of isolation wall 140. Insulator layer 123A is on sidewall 141. Insulator layer 123B is on sidewall 142. In transistor structure 101A, metal layer 127 is on insulator layer 123A on sidewall 141. In transistor structure 101B, metal layer 127 is on insulator layer 123B on sidewall 142. Notably, gate dielectric layers 122A, 122B on nanoribbons 120 may be absent from sidewalls 141, 142 of isolation wall 140, as in the exemplary embodiment of FIG. 1A.

Nanoribbons 120 in stack 121A may be the same or different than nanoribbons 120 in stack 121B. For example, nanoribbons 120 in the different stacks 121A, 121B may be of the same or different materials, have the same or different thicknesses, etc. Nanoribbons 120 may have any suitable width (and may be, e.g., nanowire nanoribbons 120 or nanosheet nanoribbons 120). Nanoribbons 120 may be of any suitable (e.g., semiconducting) material(s). In many embodiments, nanoribbons 120 include silicon. In some embodiments, at least some of nanoribbons 120 include germanium.

Gate vias 129 are metallization structures that couple (e.g., electrically couple) gate electrodes 126, for example, with an interconnect network (not shown) above transistor structures 101. Vias 129 may include any suitable material(s), including non-metals. Vias 129 may include multiple layers of metals, for example, a liner (e.g., barrier or seed) layer around a fill layer. Gate vias 129 are through a dielectric layer 149 over transistor structures 101A, 101B. Dielectric layer 149 may be of any suitable material, such as a low-k dielectric material.

Substrate 199 may include any suitable material or materials. Substrate 199 may be an IC substrate, such as an IC die or wafer. In some examples, the substrate may include monocrystalline silicon (including silicon on insulator (SOI)), polycrystalline silicon, germanium, silicon germanium, a III-V alloy material (e.g., gallium arsenide), a silicon carbide (e.g., SiC), a sapphire (e.g., Al₂O₃), or any combination thereof. Substrate 199 may also include semiconductor materials, metals, dielectrics, dopants, and other materials commonly found in semiconductor substrates. Substrate 199 may refer specifically to a base material (for example, a thick base or layer of semiconductor material) that other materials (such as metals and dielectrics) are built up on. In some contexts, substrate 199 may refer to a base material layer and any build-up layers, etc., over the base. Transistor structures 101 may be over a dielectric layer over other (e.g., semiconductor) materials.

FIG. 1B illustrates one or more gate stacks 125 on and between nanoribbons 120 in multiple, aligned stacks 121 and transistor structures 101 in device 100. Stacks 121 of nanoribbons 120 extend between, and couple, source or drain bodies 110. Any of transistor structures 101 in FIG. 1B may be either of structures 101A, 101B, as described at FIG. 1A. For example, gate stack 125 in FIG. 1B may be either of stacks 125A, 125B, as described at FIG. 1A. Dielectric wall 140 (not shown in FIG. 1B) is between and in contact with both source or drain bodies 110 in transistor structures 101A, 101B.

Source or drain bodies 110 are electrically and physically coupled to ends of nanoribbons 120 (e.g., channel regions). Source or drain bodies 110 may be impurity doped regions, e.g., regions of semiconductor material doped with one or more electrically active impurities and having increased charge-carrier availabilities and associated conductivities. Bodies 110 in different transistor structures 101 may be doped with an opposite type (e.g., n- or p-type) or of similar type. Source or drain bodies 110 may include a predominant semiconductor material, and one or more n-dopants (such as phosphorus, arsenic, or antimony) or p-type impurities (such as boron or aluminum). Other dopant materials may be used. Any suitable means of formation may be used. Bodies 110 may be epitaxially grown semiconductor regions, for example, of a Group IV semiconductor material (e.g., Si, Ge, SiGe, GeSn alloy). Other semiconductor materials may be employed. Bodies 110 may be substantially crystalline. Source or drain bodies 110 may be polycrystalline or substantially monocrystalline, e.g., having long-range order at least adjacent ends of nanoribbons 120 (e.g., to both sides of bodies 110) and merging or joining into a unitary body with few grain boundaries.

Source or drain bodies 110 are electrically and physically coupled to opposite ends of nanoribbons 120 (e.g., channel regions). In many embodiments, transistor structures 101 are each physically symmetrical about nanoribbons 120 (e.g., channel regions) and gate electrodes 126, and identifiers "drain" and "source" for bodies 110 may be reversed interchangeably in many contexts. However, the classification of source or drain bodies 110 may be by the electrical relationships of transistor structures 101 and bodies 110 to other components in a given circuit (e.g., and the consequent direction of current flow through structures 101 and bodies 110). Some source or drain bodies 110 may simultaneously be a source body 110 in one transistor structure 101 and a drain body 110 in another transistor structure 101.

Source and drain contact structures 115 are metallization structures 115 that couple (e.g., electrically couple) bodies 110, for example, with an interconnect network (not shown) above transistor structures 101. Contact structures 115 may include any suitable material(s), including non-metals. For example, contact structures 115 may include an interface (e.g., silicide) layer on bodies 110. Structures 115 may include multiple layers of metals, for example, a liner (e.g., barrier or seed) layer around a fill layer.

Contact vias 119 are metallization structures that couple (e.g., electrically couple) contact structures 115, for example, with an interconnect network (not shown) above transistor structures 101. Vias 119 may include any suitable material(s), including non-metals. Vias 119 may include multiple layers of metals, for example, a liner (e.g., barrier or seed) layer around a fill layer.

Spacers 147, 148 are isolation structures, e.g., of insulator material (such as a low-k dielectric), adjacent gate electrodes 126. Spacers 148 provide isolation between electrodes 126 and bodies 110. Spacers 147 provide isolation between electrodes 126 and bodies 110 and contact structures 115 over bodies 110.

FIG. 1C shows dielectric wall 140 between and in contact with source or drain bodies 110 in both of transistor structures 101A, 101B. View 105 illustrates a cross-sectional, y-z profile view through dielectric walls 140 and source or drain bodies 110 in transistor structures 101A, 101B. View 106 shows a cross-sectional, x-y plan view through dielectric walls 140, source or drain bodies 110, and gate electrodes 126 in transistor structures 101A, 101B. Each wall 140 is between a pair of source or drain bodies 110, and each body 110 is between a pair of dielectric walls 140. Each wall 140 has sidewalls 141, 142 on different source or drain bodies 110, and each body 110 is (on and) between dielectric sidewalls 141, 142 of different dielectric walls 140.

FIG. 2 is a flow chart of methods 200 for forming different gate stacks in adjacent transistors, in accordance with some embodiments. Methods 200 include operations 201-212. Some operations shown in FIG. 2 are optional. Additional operations may be included. FIG. 2 shows an example sequence, but the operations can be done in other orders as well, and some operations may be omitted. Some operations can also be performed multiple times before other operations are performed. For example, multiple layers of a same type may be grown or deposited before the next type of layer is grown or deposited. Some operations may be included within other operations so that the number of operations illustrated in FIG. 2 is not a limitation of the methods 200.

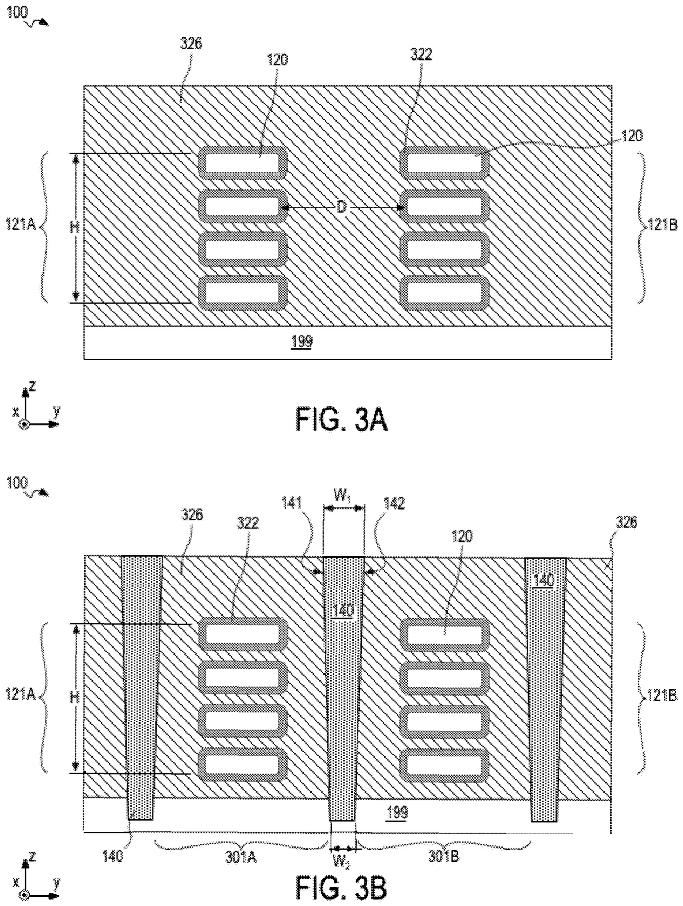

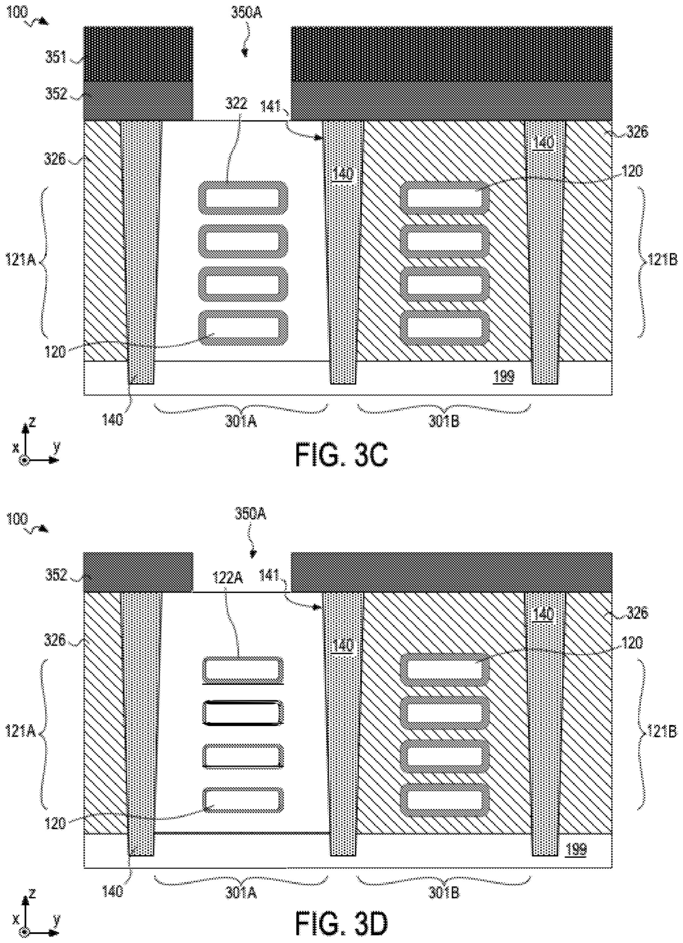

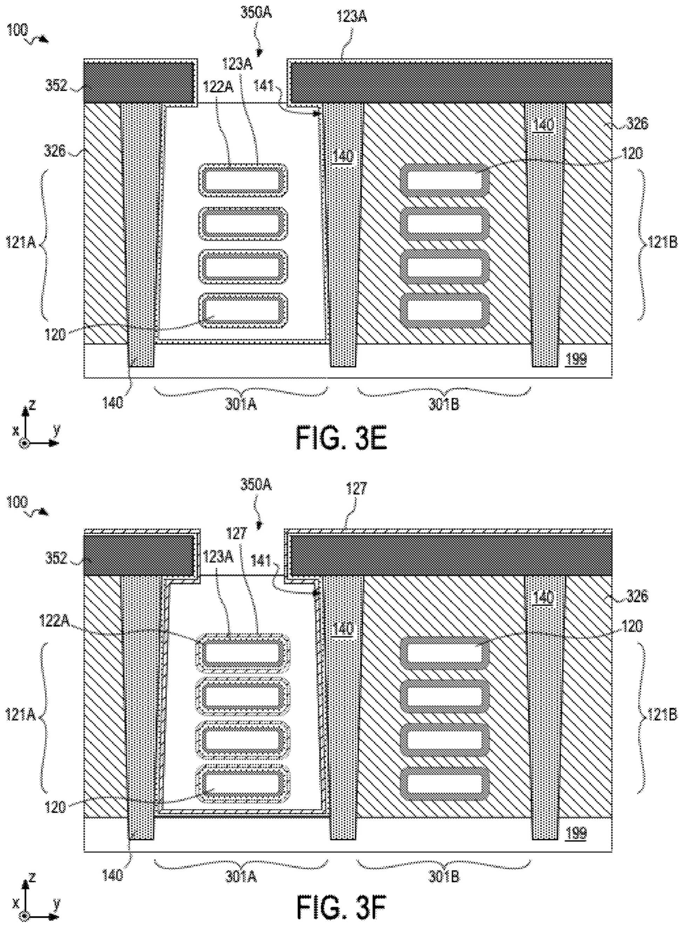

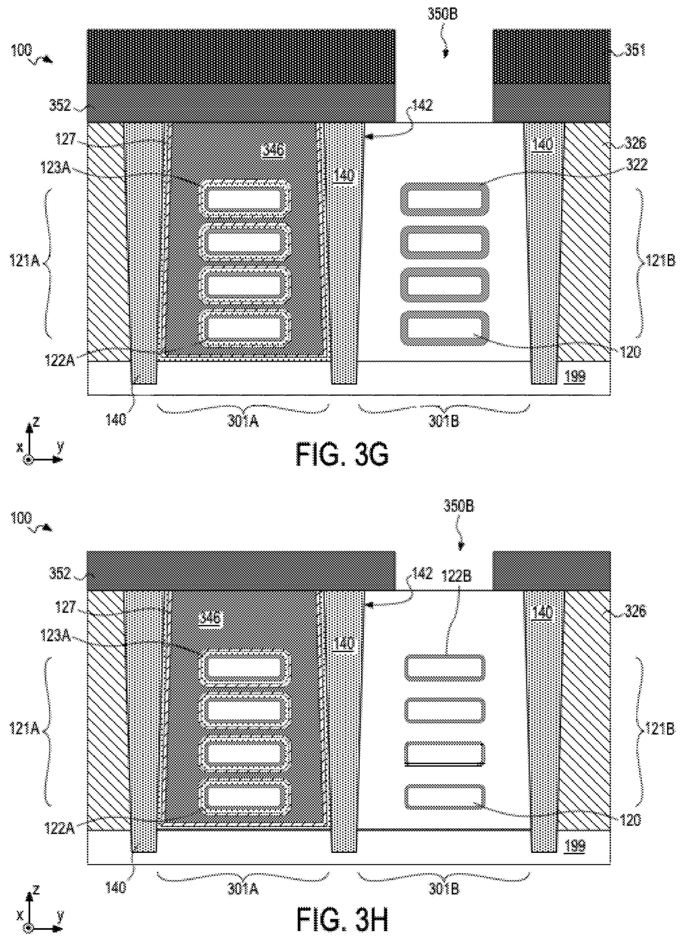

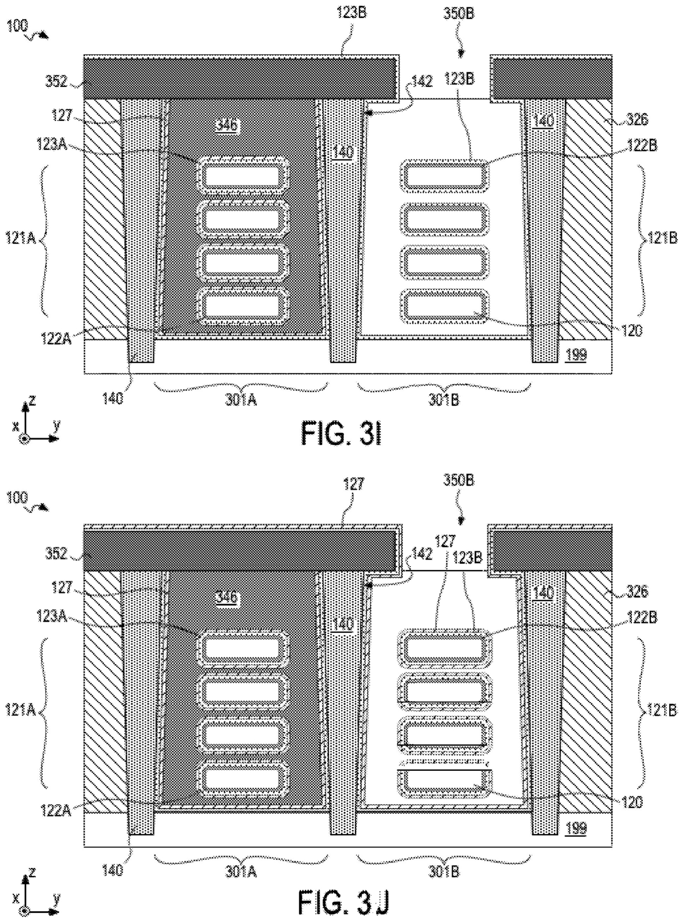

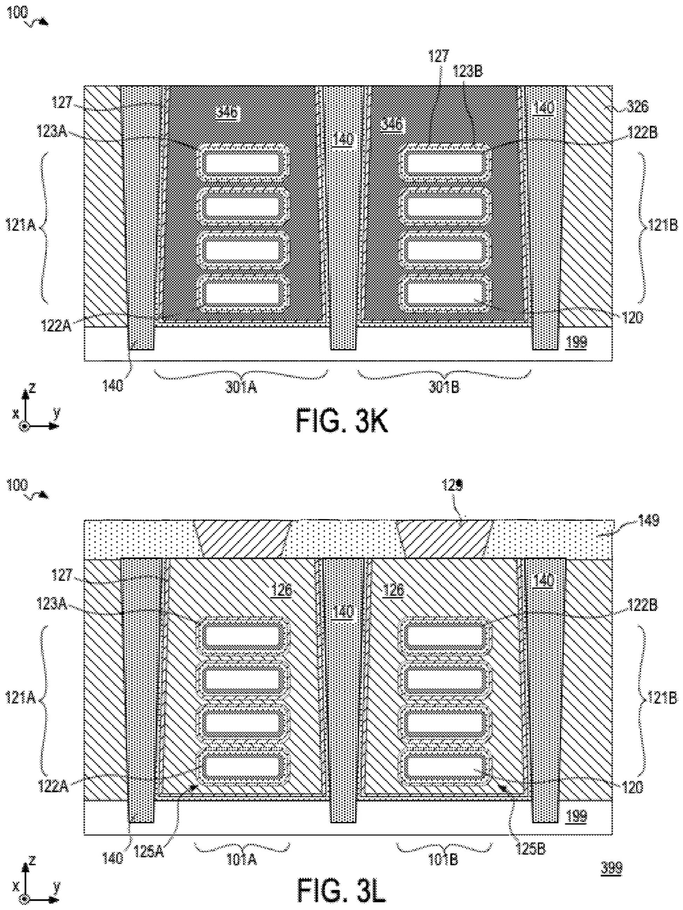

FIGS. 3A, 3B, 3C, 3D, 3E, 3F, 3G, 3H, 3I, 3J, 3K, and 3L illustrate cross-sectional profile views of a workpiece or device 100 with transistor structures 101A, 101B having different gate stacks 125A, 125B in adjacent gate electrodes 126 separated by a slim dielectric wall 140, at various stages of manufacture, in accordance with some embodiments. FIGS. 3A-3L show possible examples of intermediate structures during an embodiment of a practice of methods 200 of FIG. 2.

Returning to FIG. 2, methods 200 begin at optional operation 201 with growing an interface layer over nanoribbons in adjacent nanoribbon stacks. The interface layer may be between the nanoribbons and a subsequently deposited dummy gate. The interface layer may be a protective layer, e.g., that shields the nanoribbons from subsequent processing. For example, the interface layer may be a passivation layer (e.g., of a native oxide) that protects the nanoribbons from a subsequent deposition (and removal etch) of a dummy gate. Each nanoribbon may be covered by a thin interface (e.g., passivation) layer separate from the other nanoribbons and interface layers. In many embodiments, the interface layer includes oxygen. In many embodiments, the interface layer is on nanoribbons that include silicon, and the interface layer includes oxygen and silicon. The interface layer may be grown by any suitable means. In some embodiments, the interface layer is grown by exposure to oxygen, e.g., with an ozone treatment.

The nanoribbon stacks may be received on or in a substrate, such as an IC die or wafer, e.g., much as described of substrate 199 at FIG. 1A. The nanoribbons and nanoribbon stacks may be much as described of nanoribbons 120 and stacks 121A, 121B at FIG. 1A. For example, the adjacent nanoribbon stacks may be separated by a distance shorter than a half or two-thirds of a height of one of the nanoribbon stacks.

Returning to FIG. 2, methods 200 continue at operation 202 with forming a dummy gate over the nanoribbon stacks. The dummy gate may be grown by any suitable means. In many embodiments, the dummy gate is formed by depositing a metal over and between nanoribbons in the first stack and between nanoribbons in the second stack. In some such embodiments, the metal is deposited on the protective layers on the nanoribbons. In some embodiments, the deposited metal is tungsten. The dummy gate may be of any suitable material(s), for example, a material that may be etched through by a high-aspect ratio etch.

FIG. 3A shows interface layers 322 on nanoribbons 120 and dummy gate 326 on layers 322 and over nanoribbons 120 in workpiece or IC device 100, in accordance with some embodiments, for example, following a performance of growing and forming operations 201 and 202. Nanoribbons 120 are in adjacent stacks 121A, 121B separated by a distance D. In the exemplary embodiment of FIG. 3A, nanoribbons 120 and substrate 199 include silicon, interface layers 322 include silicon and oxygen, and dummy gate 326 includes tungsten.

Returning to FIG. 2, methods 200 continue by forming an isolation structure between the first and second stacks of nanoribbons at operation 203. The isolation structure may be formed by any suitable means. In many embodiments, the isolation structure is formed between first and second portions of a dummy gate. For example, the isolation structure may be formed by etching between first and second portions of the dummy gate and by depositing a dielectric material in the opening etched between the first and second portions. The etch may be a dry, anisotropic etch or any other suitable etch. The isolation structure may have opposing first and second sidewalls with the first portion of the dummy gate on the first sidewall and the second portion of the dummy gate on the second sidewall. Multiple isolation structures may be formed with each of the first and second stacks of nanoribbons between pairs of adjacent isolation structures.

In many embodiments, forming the isolation structure forms separate first and second tubs with the first stack of nanoribbons in the first tub and the second stack of nanoribbons in the second tub, for example, with each tub between a pair of adjacent isolation structures. In some embodiments, both the first and second tubs include no third stack of nanoribbons, e.g., the first stack of nanoribbons (and no other nanoribbon stack) is in the first tub and the second stack of nanoribbons (and no other nanoribbon stack) is in the second tub.

The isolation structure may include any suitable material(s), such as a low-k dielectric material. The isolation structure may be much as described of dielectric wall 140 at FIG. 1A. In many embodiments, the isolation structure includes silicon and nitrogen.

FIG. 3B illustrates isolation walls 140 through dummy gate 326 and between adjacent nanoribbon stacks 121A, 121B and gate tubs 301A, 301B in workpiece or device 100, in accordance with some embodiments, for example, following a performance of forming operation 203. In the exemplary embodiment of FIG. 3B, portions of dummy gate 326 are still in gate tubs 301. Other gate tubs 301 may be to the sides (e.g., in the y-directions) of tubs 301A, 301B and dielectric walls 140.

Returning to FIG. 2, methods 200 continue with opening a first cavity on a first side of the isolation structure at operation 204. The first cavity may be a gate tub for processing the first stack of nanoribbons. The first cavity may be opened by any suitable means. In many embodiments, the first cavity is opened by removing the first portion of the dummy gate from the first sidewall and from over the first stack of nanoribbons. In many embodiments, the dummy gate material is removed by a selective isotropic etch. In some embodiments, a mask layer is deposited over the substrate (including the dummy gate and isolation structures), a mask opening is patterned over the first stack of nanoribbons, and the dummy gate material is removed from the first side of the isolation structure. The mask opening may be patterned with an edge-placement error or more to the isolation structure, e.g., to ensure the mask opening is always over the correct tub.

FIG. 3C shows mask layers 351, 352 over dummy gate 326, walls 140, stacks 121A, 121B, and tubs 301A, 301B, and first cavity 350A under and through layers 351, 352, in workpiece or device 100, in accordance with some embodiments, for example, following a performance of opening operation 204. A material (e.g., metal) of dummy gate 326 has been removed from gate tub 301A, and nanoribbon stack 121A is in cavity 350A in gate tub 301A. Interface layers 322 on nanoribbons 120 of stack 121A are exposed. Sidewall 141 of isolation wall 140 is exposed.

Returning to FIG. 2, methods 200 continue at operation 205 by removing the interface layer from the nanoribbons in the first nanoribbon stack. The interface layer may be removed by any suitable means. In many embodiments, the interface layer is removed by an etch of hydrofluoric acid (e.g., dilute hydrofluoric acid, DHF), for example, following an ozone treatment.

Returning to FIG. 2, methods 200 continue at operation 206 with forming a first dielectric stack on the nanoribbons in the first nanoribbon stack. The first dielectric stack may be formed by any suitable means. In many embodiments, a dielectric layer is grown on the nanoribbons in the first nanoribbon stack. In many embodiments, an insulator layer is deposited on the dielectric layer grown on the nanoribbons in the first nanoribbon stack. In some embodiments, a dipole dopant is deposited on the dielectric layer on the first nanoribbons or on the deposited insulator layer on the grown dielectric layer.

The dielectric layer grown on the first nanoribbon stack may be similar to the interface layer, e.g., a native oxide or passivation layer grown from the nanoribbons. The dielectric layer may be formed by any suitable means and of any suitable materials. The dielectric layer on the first nanoribbon stack may be much as described of layer 122A at FIG. 1A, for example, having silicon and oxygen and a thickness T₁. Although the dielectric layer may be similar to the interface layer (e.g., grown at operation 201), the dielectric layer may be grown in a more controlled fashion, for example, to a precise and controlled thickness. In some embodiments, the dielectric layer is grown from the nanoribbons, and a portion of a thickness of the dielectric layer is consumed from a thickness of the nanoribbon. A thicker dielectric layer may correspond with a further-thinned nanoribbon. In many embodiments, the dielectric layer is grown on the first nanoribbon stack using an ozone treatment.

An insulator layer may be deposited on the grown dielectric layer on the first nanoribbons. In many embodiments, the deposited insulator layer is a high-k dielectric layer. The deposited insulator layer may be much as described of layer 123A at FIG. 1A, for example, having oxygen and hafnium and/or zirconium and a thickness T₃. The deposited insulator layer may be formed by any suitable means and of any suitable materials. In many embodiments, the insulator layer is deposited on the grown dielectric layer on the first nanoribbons by an atomic layer deposition (ALD), which may conformally deposit the insulator layer in the gate tub (and beyond, over the entire substrate). In many embodiments, the insulator layer is deposited on the first side (e.g., first sidewall) of the isolation structure. An ALD (or another suitable depositing means) may deposit the insulator layer in an extremely controlled fashion and to a precise and controlled thickness.

A dipole dopant may be deposited on the dielectric layer grown on the first nanoribbons or on the deposited insulator layer on the grown dielectric layer. In some embodiments, an anneal (e.g., at an elevated temperature) is performed, for example, to drive the dipole dopant into either the grown dielectric layer or the deposited insulator layer on the grown dielectric layer. The dipole dopant may be in the grown dielectric layer (e.g., at some depth, inclusive, between the first interface between the nanoribbons and the grown dielectric layer and a second interface between the grown dielectric layer and the deposited insulator layer) or in or on the deposited insulator layer (e.g., at some depth, inclusive, between the second interface between the grown dielectric layer and the deposited insulator layer and an outer surface of the deposited insulator layer). The anneal (e.g., to drive the dipole dopant into either of the layers) may be performed at any suitable point during methods 200, for example, before or after insulator layers are deposited on nanoribbons in the second nanoribbon stack. A separate anneal (e.g., done on only the insulator layers on nanoribbons in the first nanoribbon stack) may drive the dipole dopant to a different depth in the first nanoribbons than in the second nanoribbons.

FIG. 3D illustrates dielectric layer 122A on nanoribbons 120 in first stack 121A, first cavity 350A, and first gate tub 301A, in workpiece or device 100, in accordance with some embodiments, for example, following a performance of removing and forming operations 205 and 206. Notably, dielectric layer 122A is on nanoribbons 120 in first nanoribbon stack 121A, but not on sidewall 141 (or other sidewalls of first cavity 350A and tub 301A).

FIG. 3E shows insulator layer 123A on dielectric layer 122A on nanoribbons 120 in first stack 121A, first cavity 350A, and first gate tub 301A in workpiece or device 100, in accordance with some embodiments, for example, following a performance of forming operation 206. Notably, insulator layer 123A is over layer 122A and nanoribbons 120 in nanoribbon stack 121A, as well as conformally on sidewall 141 (and other sidewalls of first cavity 350A and tub 301A) and mask layer 352.

Returning to FIG. 2, methods 200 continue by depositing a first metal layer on the first dielectric stack at operation 207. The first metal layer may be a capping layer that protects the dielectric stack, for example, from further processing. In many embodiments, the first metal layer is a WFM layer. The first metal layer may be much as described of layer 127 in first gate stack 125A at FIG. 1A, for example, having a thickness T₅. The first metal layer may be formed by any suitable means and of any suitable materials, including non-metallic materials. In many embodiments, the first metal layer includes nitrogen (e.g., in a metal nitride). In some embodiments, the first metal layer includes titanium and nitrogen (e.g., in a nitride of titanium). In many embodiments, the first metal layer is deposited by a CVD (chemical vapor deposition) or ALD.

The cavity or gate tub may be filled with a sacrificial material, e.g., to cover the deposited gate stack layers during further processing. The sacrificial material may help retain the deposited layers adjacent the nanoribbons while allowing removal of the layers elsewhere, such as on a hardmask layer over the gate tubs. In some embodiments, the sacrificial material includes carbon (e.g., in a carbon hardmask). In some embodiments, the sacrificial material is cured with a nitrogen treatment. In some embodiments, the deposited layers on a hardmask layer over the gate tubs are removed by one or more isotropic etches and/or a CMP (chemical-mechanical planarization or polish).

FIG. 3F illustrates first metal layer 127 on insulator layer 123A on dielectric layer 122A on nanoribbons 120 in first stack 121A, first cavity 350A, and first gate tub 301A in workpiece or device 100, in accordance with some embodiments, for example, following a performance of depositing operation 207. Notably, metal layer 127 is on insulator layer 123A in nanoribbon stack 121A, as well as conformally on insulator layer 123A over sidewall 141 (and other sidewalls of first cavity 350A and tub 301A) and mask layer 352.

Returning to FIG. 2, methods 200 continue with opening a second cavity on a second side of the isolation structure at operation 208. The performance of operation 208 may be similar to the performance of operation 204, e.g., except on an opposing side of the isolation structure. The second cavity may be a gate tub for processing the second stack of nanoribbons. The second cavity may be opened by any suitable means. In many embodiments, the second cavity is opened by removing the second portion of the dummy gate from the second sidewall and from over the second stack of nanoribbons. In many embodiments, the dummy gate material is removed by a selective isotropic etch. In some embodiments, a mask layer is deposited over the substrate, a mask opening is patterned over the second stack of nanoribbons, and the dummy gate material is removed from the second side of the isolation structure. The deposited mask layer may be a second mask layer following a removal (for example, by a CMP) of a first mask layer (e.g., at operation 204, etc.).

FIG. 3G shows mask layers 351, 352 over dummy gate 326, walls 140, stacks 121A, 121B, and tubs 301A, 301B, and second cavity 350B under and through layers 351, 352, in workpiece or device 100, in accordance with some embodiments, for example, following a performance of opening operation 208. A material (e.g., metal) of dummy gate 326 has been removed from gate tub 301B, and nanoribbon stack 121B is in cavity 350B in gate tub 301B. Interface layers 322 on nanoribbons 120 of stack 121B are exposed. Sidewall 142 of isolation wall 140 is exposed. A sacrificial material 346 is on layer 127 in first gate tub 301A.

Returning to FIG. 2, methods 200 continue at operation 209 by removing the interface layer from the nanoribbons in the second nanoribbon stack. The performance of operation 209 may be similar to the performance of operation 205, e.g., except on the second nanoribbon stack. The interface layer may be removed by any suitable means. In many embodiments, the interface layer is removed by a hydrofluoric acid etch.

Returning to FIG. 2, methods 200 continue at operation 210 with forming a second dielectric stack on the nanoribbons in the second nanoribbon stack. The performance of operation 210 may be similar to the performance of operation 206, e.g., except on the second nanoribbon stack. Significantly, the performance of operation 210 on the second nanoribbon stack may be done with different materials, to different dimensions, etc., and the second dielectric stack may have different characteristics than the first dielectric stack. The second dielectric stack may be formed by any suitable means. In many embodiments, a dielectric layer is grown on the nanoribbons in the second nanoribbon stack. In many embodiments, an insulator layer is deposited on the dielectric layer grown on the nanoribbons in the second nanoribbon stack. In some embodiments, a dipole dopant is deposited on the dielectric layer on the second nanoribbons or on the deposited insulator layer on the grown dielectric layer.

The dielectric layer may be formed on the second nanoribbons by any suitable means and of any suitable materials. The dielectric layer on the second nanoribbon stack may be much as described of layer 122B at FIG. 1A, for example, having silicon and oxygen and a thickness T₂. Notably, the dielectric layer formed on the second nanoribbons may have a different thickness or material composition than the dielectric layer formed on the first nanoribbons.

An insulator layer may be deposited on the grown dielectric layer on the second nanoribbons. In many embodiments, the deposited insulator layer is a high-k dielectric layer. The deposited insulator layer may be much as described of layer 123B at FIG. 1A, for example, having oxygen and hafnium and/or zirconium and a thickness T₄. The deposited insulator layer may be formed by any suitable means and of any suitable materials. Notably, the deposited insulator layer formed over the second nanoribbons may have a different thickness or material composition than the deposited insulator layer formed over the first nanoribbons.

A dipole dopant may be deposited on the dielectric layer grown on the second nanoribbons or on the deposited insulator layer over the second nanoribbons. Notably, the dipole dopant deposited over the second nanoribbons may be of the same or a different material than the dopant deposited over the first nanoribbons and may be deposited at a different concentration or thickness, or driven to a different depth in the corresponding dielectric stack than the dopant deposited over the first nanoribbons.

FIG. 3H illustrates dielectric layer 122B on nanoribbons 120 in second stack 121B, second cavity 350B, and second gate tub 301B, in workpiece or device 100, in accordance with some embodiments, for example, following a performance of removing and forming operations 209 and 210. Notably, dielectric layer 122B is on nanoribbons 120 in second nanoribbon stack 121B, but not on sidewall 142 (or other sidewalls of second cavity 350B and tub 301B).

FIG. 3I shows insulator layer 123B on dielectric layer 122B on nanoribbons 120 in second stack 121B, second cavity 350B, and second gate tub 301B in workpiece or device 100, in accordance with some embodiments, for example, following a performance of forming operation 210. Notably, insulator layer 123B is over layer 122B and nanoribbons 120 in nanoribbon stack 121B, as well as conformally on sidewall 142 (and other sidewalls of second cavity 350B and tub 301B) and mask layer 352.

Returning to FIG. 2, methods 200 continue by depositing a second metal layer on the second dielectric stack at operation 211. The performance of operation 211 may be similar to the performance of operation 207, e.g., except on the second dielectric stack. Significantly, the performance of operation 211 on the second dielectric stack may be done with different materials, to different dimensions, etc., and the second gate stack may have different characteristics than the first gate stack. The second metal layer may be a capping layer that protects the second dielectric stack, for example, from further processing. In many embodiments, the second metal layer is a WFM layer. The second metal layer may be much as described of layer 127 in second gate stack 125B at FIG. 1A, for example, having a thickness T₆. The second metal layer may be formed by any suitable means and of any suitable materials, including non-metallic materials. In many embodiments, the second metal layer includes nitrogen. In some embodiments, the second metal layer includes titanium and nitrogen.

FIG. 3J illustrates second metal layer 127 on insulator layer 123B on dielectric layer 122B on nanoribbons 120 in second stack 121B, second cavity 350B, and second gate tub 301B in workpiece or device 100, in accordance with some embodiments, for example, following a performance of depositing operation 211. Notably, metal layer 127 is on insulator layer 123B in nanoribbon stack 121B, as well as conformally on insulator layer 123B over sidewall 142 (and other sidewalls of second cavity 350B and tub 301B) and mask layer 352.

Returning to FIG. 2, methods 200 continue at operation 212 by forming a first gate electrode over the first nanoribbon stack and a second gate electrode over the second nanoribbon stack. The isolation structure may be retained, and the first and second gate electrodes may be separated by the isolation structure. The first and second gate electrodes may be formed by any suitable means and of any suitable materials, including non-metallic materials. The first and second gate electrodes may be much as described of electrodes 126 in transistor structures 101a, 101B at FIG. 1A (for example, having layers 127, 128). The first and second gate electrodes may be formed of the same or different materials, e.g., having the same or different layers 127, 128. The first and second gate electrodes may be separated by a width of the isolation structure less than half or a third of a height of the first or second nanoribbon stacks.

FIG. 3K shows sacrificial material 346 on layers 127 in first and second gate tubs 301A, 301B in workpiece or device 100, in accordance with some embodiments, for example, during or prior to a performance of forming operation 212. Mask layers are not present over dummy gate 326, walls 140, stacks 121A, 121B, and tubs 301A, 301B.

FIG. 3L illustrates IC device 100 with transistor structures 101A, 101B having different gate stacks 125A, 125B in adjacent gate electrodes 126 separated by a slim dielectric wall 140, in accordance with some embodiments, for example, following a performance of forming operation 212. Gate vias 129 through dielectric layer 149 couple gate electrodes 126 and transistor structures 101A, 101B, for example, with an interconnect network (not shown) above structures 101.

IC device 100 may include or be coupled to a substrate or other host component 399. Host component 399 may be a package substrate, an interposer, an IC die, etc. For example, substrate 199 may be an IC die that includes transistor structures 101, substrate 199 may be coupled (e.g., soldered or otherwise bonded) to host component 399, and device 100 and transistor structures 101 may be coupled to a power supply (not shown) through host component 399.

Host component 399 is a planar platform and may include dielectric and metallization structures. Host component 399 mechanically supports and electrically couples one or more IC devices 100. At least one side of host component 399 includes substrate interconnect interfaces for bonding to one or more IC devices 100. IC device 100 may be direct bonded, e.g., hybrid bonded, to host component 399 or otherwise bonded, e.g., by optional solder bumps. The opposite side of host component 399 may include similar interfaces, e.g., copper pads for socketing and/or solder bumps for bonding device 100 to a host component, such as a printed circuit board (PCB). Host component 399 may be any host component with substrate interconnect interfaces, such as a package host component 399 or interposer, etc. Host component 399 may itself be a die. In many embodiments, host component 399 includes organic dielectric(s), such as a resin or other polymer, between metallization layers.

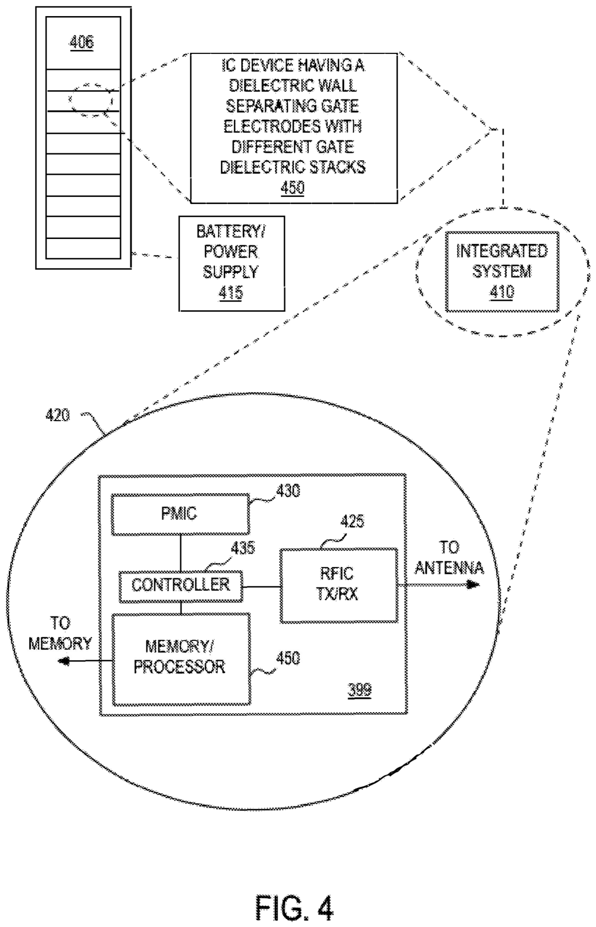

FIG. 4 illustrates a diagram of an example data server machine 406 employing an IC device having a dielectric wall separating gate electrodes with different gate dielectric stacks, in accordance with some embodiments. Server machine 406 may be any commercial server, for example, including any number of high-performance computing platforms disposed within a rack and networked together for electronic data processing, which in the exemplary embodiment includes one or more devices 450 having a dielectric wall separating gate electrodes with different gate dielectric stacks.

Also as shown, server machine 406 includes a battery and/or power supply 415 to provide power to devices 450, and to provide, in some embodiments, power delivery functions such as power regulation. Devices 450 may be deployed as part of a package-level integrated system 410. Integrated system 410 is further illustrated in the expanded view 420. In the exemplary embodiment, devices 450 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 450 is a microprocessor including a static RAM (SRAM) cache memory. As shown, device 450 may be an IC device having a dielectric wall separating gate electrodes with different gate dielectric stacks, as discussed herein. Device 450 may be further coupled to (e.g., communicatively coupled to) a board, an interposer, or other substrate or host component 399 along with, one or more of a power management IC (PMIC) 430, RF (wireless) IC (RFIC) 425 including a wideband RF (wireless) transmitter and/or receiver (TX/RX) (e.g., including a digital baseband and an analog front end module further includes a power amplifier on a transmit path and a low noise amplifier on a receive path), and a controller 435 thereof. In some embodiments, RFIC 425, PMIC 430, controller 435, and device 450 include a dielectric wall separating gate electrodes with different gate dielectric stacks.

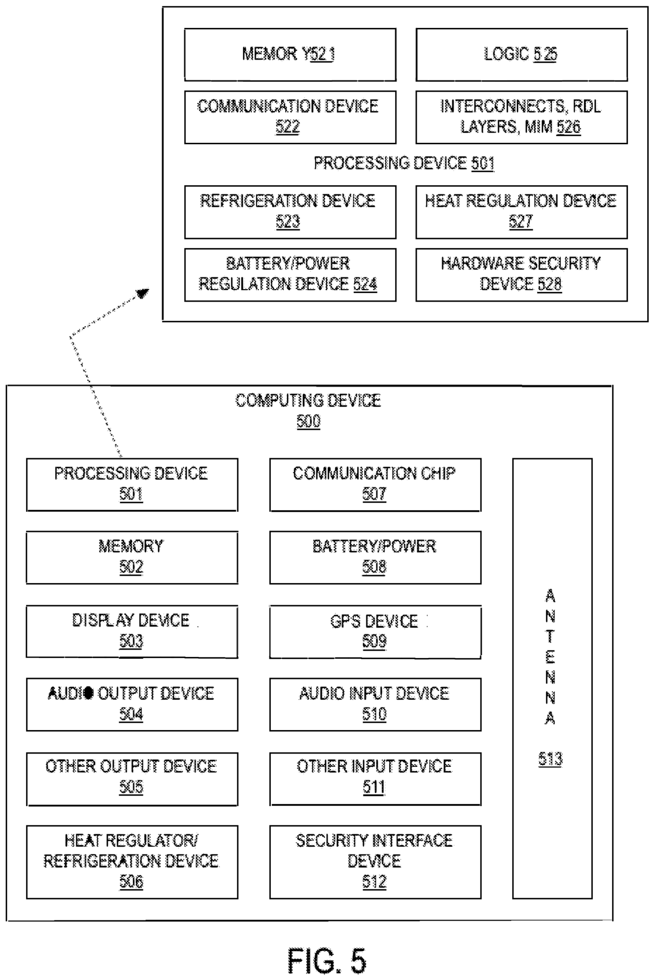

FIG. 5 is a block diagram of an example computing device 500, in accordance with some embodiments. For example, one or more components of computing device 500 may include any of the devices or structures discussed herein. A number of components are illustrated in FIG. 5 as being included in computing device 500, but any one or more of these components may be omitted or duplicated, as suitable for the application. In some embodiments, some or all of the components included in computing device 500 may be attached to one or more printed circuit boards (e.g., a motherboard). In some embodiments, various ones of these components may be fabricated onto a single system-on-a-chip (SoC) die. Additionally, in various embodiments, computing device 500 may not include one or more of the components illustrated in FIG. 5, but computing device 500 may include interface circuitry for coupling to the one or more components. For example, computing device 500 may not include a display device 503, but may include display device interface circuitry (e.g., a connector and driver circuitry) to which display device 503 may be coupled. In another set of examples, computing device 500 may not include an audio output device 504, other output device 505, global positioning system (GPS) device 509, audio input device 510, or other input device 511, but may include audio output device interface circuitry, other output device interface circuitry, GPS device interface circuitry, audio input device interface circuitry, audio input device interface circuitry, to which audio output device 504, other output device 505, GPS device 509, audio input device 510, or other input device 511 may be coupled.

Computing device 500 may include a processing device 501 (e.g., one or more processing devices). As used herein, the term "processing device" or "processor" indicates a device that processes electronic data from registers and/or memory to transform that electronic data into other electronic data that may be stored in registers and/or memory. Processing device 501 may include a memory 521, a communication device 522, a refrigeration device 523, a battery/power regulation device 524, logic 525, interconnects 526 (i.e., optionally including redistribution layers (RDL) or metal-insulator-metal (MIM) devices), a heat regulation device 527, and a hardware security device 528.

Processing device 501 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 500 may include a memory 502, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 502 includes memory that shares a die with processing device 501. This memory may be used as cache memory and may include embedded dynamic random-access memory (eDRAM) or spin transfer torque magnetic random-access memory (STT-MRAM).

Computing device 500 may include a heat regulation/refrigeration device 506. Heat regulation/refrigeration device 506 may maintain processing device 501 (and/or other components of computing device 500) at a predetermined low temperature during operation.

In some embodiments, computing device 500 may include a communication chip 507 (e.g., one or more communication chips). For example, the communication chip 507 may be configured for managing wireless communications for the transfer of data to and from computing device 500. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 507 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 507 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 507 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 507 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 507 may operate in accordance with other wireless protocols in other embodiments. Computing device 500 may include an antenna 513 to facilitate wireless communications and/or to receive other wireless communications (such as AM or FM radio transmissions).

In some embodiments, communication chip 507 may manage wired communications, such as electrical, optical, or any other suitable communication protocols (e.g., the Ethernet). As noted above, communication chip 507 may include multiple communication chips. For instance, a first communication chip 507 may be dedicated to shorter-range wireless communications such as Wi-Fi or Bluetooth, and a second communication chip 507 may be dedicated to longer-range wireless communications such as GPS, EDGE, GPRS, CDMA, WiMAX, LTE, EV-DO, or others. In some embodiments, a first communication chip 507 may be dedicated to wireless communications, and a second communication chip 507 may be dedicated to wired communications.

Computing device 500 may include battery/power circuitry 508. Battery/power circuitry 508 may include one or more energy storage devices (e.g., batteries or capacitors) and/or circuitry for coupling components of computing device 500 to an energy source separate from computing device 500 (e.g., AC line power).

Computing device 500 may include a display device 503 (or corresponding interface circuitry, as discussed above). Display device 503 may include any visual indicators, such as a heads-up display, a computer monitor, a projector, a touchscreen display, a liquid crystal display (LCD), a light-emitting diode display, or a flat panel display, for example.

Computing device 500 may include an audio output device 504 (or corresponding interface circuitry, as discussed above). Audio output device 504 may include any device that generates an audible indicator, such as speakers, headsets, or earbuds, for example.

Computing device 500 may include an audio input device 510 (or corresponding interface circuitry, as discussed above). Audio input device 510 may include any device that generates a signal representative of a sound, such as microphones, microphone arrays, or digital instruments (e.g., instruments having a musical instrument digital interface (MIDI) output).

Computing device 500 may include a GPS device 509 (or corresponding interface circuitry, as discussed above). GPS device 509 may be in communication with a satellite-based system and may receive a location of computing device 500, as known in the art.

Computing device 500 may include other output device 505 (or corresponding interface circuitry, as discussed above). Examples of the other output device 505 may include an audio codec, a video codec, a printer, a wired or wireless transmitter for providing information to other devices, or an additional storage device.

Computing device 500 may include other input device 511 (or corresponding interface circuitry, as discussed above). Examples of the other input device 511 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 500 may include a security interface device 512. Security interface device 512 may include any device that provides security measures for computing device 500 such as intrusion detection, biometric validation, security encode or decode, access list management, malware detection, or spyware detection.

Computing device 500, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1A-5. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes a first plurality of first nanoribbons extending through a first gate structure in a first transistor structure, the first gate structure including a first dielectric stack having a first thickness of first and second dielectric layers, the first dielectric layers on the first nanoribbons, the second dielectric layers on the first dielectric layers, a second plurality of second nanoribbons extending through a second gate structure in a second transistor structure, the second gate structure including second dielectric stack having a second thickness of third and fourth dielectric layers, the third dielectric layers on the second nanoribbons, the fourth dielectric layers on the third dielectric layers, the second thickness different than the first thickness, and a dielectric structure separating the first and second gate structures.

In one or more second embodiments, further to the first embodiments, the first transistor structure includes a first source or drain body coupled with the first nanoribbons, the second transistor structure includes a second source or drain body coupled with the second nanoribbons, the dielectric structure is a dielectric wall between and in contact with the first and second gate structures, and the dielectric wall is between and in contact with the first and second source or drain bodies.

In one or more third embodiments, further to the first or second embodiments, a first one of the first dielectric layers has a third thickness greater than a fourth thickness of a second one of the third dielectric layers.

In one or more fourth embodiments, further to the first through third embodiments, a first one of the second dielectric layers has a third thickness greater than a fourth thickness of a second one of the fourth dielectric layers.

In one or more fifth embodiments, further to the first through fourth embodiments, a first one of the second dielectric layers includes hafnium and zirconium and a second one of the fourth dielectric layers includes neither of or only one of hafnium and zirconium.

In one or more sixth embodiments, further to the first through fifth embodiments, the first dielectric stack includes a dipole dopant not present in the second dielectric stack or present at a first height from a first one of the first nanoribbons greater than a second height from a second one of the second nanoribbons.

In one or more seventh embodiments, further to the first through sixth embodiments, a first metal layer is on the second dielectric layer around each of the first nanoribbons, a second metal layer is on the fourth dielectric layer around each of the second nanoribbons, the dielectric structure includes opposing first and second sidewalls, the second dielectric layer is on the first sidewall, the first metal layer is on the second dielectric layer on the first sidewall, the fourth dielectric layer is on the second sidewall, and the second metal layer is on the fourth dielectric layer on the second sidewall.

In one or more eighth embodiments, further to the first through seventh embodiments, a distance separating the first plurality of first nanoribbons and the second plurality of second nanoribbons is less than three times a width of the dielectric structure separating the first gate structure and the second gate structure.

In one or more ninth embodiments, further to the first through eighth embodiments, the first and second transistor structures are of the same conductivity type.

In one or more tenth embodiments, an apparatus includes a first nanoribbon stack in a first transistor structure, a first dielectric stack on first nanoribbons in the first nanoribbon stack, a first gate electrode on the first dielectric stack, a second nanoribbon stack in a second transistor structure, a second dielectric stack on second nanoribbons in the second nanoribbon stack, a second gate electrode on the second dielectric stack, the second dielectric stack including a second thickness different than a first thickness of the first dielectric stack, and a dielectric structure separating the first and second gate electrodes, wherein a width of the dielectric structure is less than half of a height of the first nanoribbon stack.

In one or more eleventh embodiments, further to the tenth embodiments, the first dielectric stack includes first dielectric layers on the first nanoribbons and second dielectric layers on the first dielectric layers, the second dielectric stack includes third dielectric layers on the second nanoribbons and fourth dielectric layers on the third dielectric layers, and a first one of the second dielectric layers has a third thickness greater than a fourth thickness of a second one of the fourth dielectric layers.

In one or more twelfth embodiments, further to the tenth or eleventh embodiments, the first one of the second dielectric layers includes hafnium and zirconium and the second one of the fourth dielectric layers includes neither of or only one of hafnium and zirconium.

In one or more thirteenth embodiments, further to the tenth through twelfth embodiments, the apparatus is coupled to a host component, and the apparatus is coupled to a power supply through the host component.

In one or more fourteenth embodiments, a method includes forming an isolation structure through a dummy gate and between a first stack of first nanoribbons and a second stack of second nanoribbons, the isolation structure including opposing first and second sides, opening a first cavity on the first side of the isolation structure and over the first stack, forming a first dielectric stack on the first nanoribbons, opening a second cavity on the second side of the isolation structure and over the second stack, forming a second dielectric stack on the second nanoribbons, and forming a first gate electrode over the first stack and a second gate electrode over the second stack, the first and second gate electrodes separated by the isolation structure.

In one or more fifteenth embodiments, further to the fourteenth embodiments, the forming the isolation structure forms separate first and second tubs, the first stack of first nanoribbons in the first tub and the second stack of second nanoribbons in the second tub, both the first and second tubs not including a third stack of nanoribbons.

In one or more sixteenth embodiments, further to the fourteenth or fifteenth embodiments, the forming the first and second dielectric stacks forms the first and second dielectric stacks with different compositions.

In one or more seventeenth embodiments, further to the fourteenth through sixteenth embodiments, the forming the first dielectric stack on the first nanoribbons or forming the second dielectric stack on the second nanoribbons deposits a dielectric layer on a sidewall of the isolation structure.

In one or more eighteenth embodiments, further to the fourteenth through seventeenth embodiments, the method also includes forming the dummy gate by depositing a metal over and between the first nanoribbons in the first stack and between the second nanoribbons in the second stack.

In one or more nineteenth embodiments, further to the fourteenth through eighteenth embodiments, the method also includes depositing a metal layer on the first and second dielectric stacks, the metal layer including nitrogen.

In one or more twentieth embodiments, further to the fourteenth through nineteenth embodiments, the forming the isolation structure forms the isolation structure with a width shorter than half a height of a shorter of the first stack of first nanoribbons or the second stack of second nanoribbons.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
a first plurality of first nanoribbons extending through a first gate structure in a first transistor structure, the first gate structure comprising a first dielectric stack having a first thickness of first and second dielectric layers, the first dielectric layers on the first nanoribbons, the second dielectric layers on the first dielectric layers;
a second plurality of second nanoribbons extending through a second gate structure in a second transistor structure, the second gate structure comprising second dielectric stack having a second thickness of third and fourth dielectric layers, the third dielectric layers on the second nanoribbons, the fourth dielectric layers on the third dielectric layers, the second thickness different than the first thickness; and
a dielectric structure separating the first and second gate structures.

2. The apparatus of claim 1, wherein:
the first transistor structure comprises a first source or drain body coupled with the first nanoribbons;
the second transistor structure comprises a second source or drain body coupled with the second nanoribbons;
the dielectric structure is a dielectric wall between and in contact with the first and second gate structures; and
the dielectric wall is between and in contact with the first and second source or drain bodies.

3. The apparatus of claim 1 or 2, wherein a first one of the first dielectric layers has a third thickness greater than a fourth thickness of a second one of the third dielectric layers.

4. The apparatus of claim 1 or 2, wherein a first one of the second dielectric layers has a third thickness greater than a fourth thickness of a second one of the fourth dielectric layers.

5. The apparatus of any of claims 1 to 4, wherein a first one of the second dielectric layers comprises hafnium and zirconium and a second one of the fourth dielectric layers comprises neither of or only one of hafnium and zirconium.

6. The apparatus of any of claims 1 to 4, wherein the first dielectric stack comprises a dipole dopant not present in the second dielectric stack or present at a first height from a first one of the first nanoribbons greater than a second height from a second one of the second nanoribbons.

7. The apparatus of any of claims 1 to 4, wherein:
a first metal layer is on the second dielectric layer around each of the first nanoribbons;
a second metal layer is on the fourth dielectric layer around each of the second nanoribbons;
the dielectric structure comprises opposing first and second sidewalls;
the second dielectric layer is on the first sidewall;
the first metal layer is on the second dielectric layer on the first sidewall;
the fourth dielectric layer is on the second sidewall; and
the second metal layer is on the fourth dielectric layer on the second sidewall.

8. The apparatus of any of claims 1 to 4, wherein a distance separating the first plurality of first nanoribbons and the second plurality of second nanoribbons is less than three times a width of the dielectric structure separating the first gate structure and the second gate structure.

9. The apparatus of any of claims 1 to 4, wherein the first and second transistor structures are of the same conductivity type.

10. A method, comprising:
forming an isolation structure through a dummy gate and between a first stack of first nanoribbons and a second stack of second nanoribbons, the isolation structure comprising opposing first and second sides;
opening a first cavity on the first side of the isolation structure and over the first stack;
forming a first dielectric stack on the first nanoribbons;
opening a second cavity on the second side of the isolation structure and over the second stack;
forming a second dielectric stack on the second nanoribbons; and
forming a first gate electrode over the first stack and a second gate electrode over the second stack, the first and second gate electrodes separated by the isolation structure.

11. The method of claim 10, wherein the forming the isolation structure forms separate first and second tubs, the first stack of first nanoribbons in the first tub and the second stack of second nanoribbons in the second tub, both the first and second tubs absent a third stack of nanoribbons.

12. The method of claim 10 or **11,** wherein the forming the first and second dielectric stacks forms the first and second dielectric stacks with different compositions.

13. The method of any of claims 10 to 12, wherein the forming the first dielectric stack on the first nanoribbons or forming the second dielectric stack on the second nanoribbons deposits a dielectric layer on a sidewall of the isolation structure.

14. The method of any of claims 10 to 12, further comprising depositing a metal layer on the first and second dielectric stacks, the metal layer comprising nitrogen.

15. The method of any of claims 10 to 12, wherein the forming the isolation structure forms the isolation structure with a width shorter than half a height of a shorter of the first stack of first nanoribbons or the second stack of second nanoribbons.
